# EUROPÄISCHE PATENTANMELDUNG

(11) **EP 4 235 706 A2**
(43) Veröffentlichungstag der Anmeldung: **30.08.2023**
(21) Anmeldenummer: 23173676.0
(22) Anmeldetag: 15.09.2020
(51) Int. Cl.: H01C 1/14

(54) **SENSORELEMENT UND VERFAHREN ZUR HERSTELLUNG EINES SENSORELEMENTS**

(30) Priorität: 16.10.2019 DE 102019127915
(62) Teilanmeldung aus: 20772274.5
(71) Anmelder: TDK Electronics AG, 81671 München (DE)
(72) Erfinder: IHLE, Jan, 8074 Raaba-Grambach (AT); BERNERT, Thomas, 85055 Ingolstadt (DE); KLOIBER, Gerald, 8073 Feldkirchen (AT)
(74) Vertreter: Epping - Hermann - Fischer

(57) **Zusammenfassung**

Es wird ein Sensorelement zur Messung einer Temperatur beschrieben aufweisend wenigstens eine Trägerschicht (2), wobei die Trägerschicht (2) eine Oberseite (2a) und eine Unterseite (2b) aufweist, wenigstens eine Funktionsschicht (5), wobei die Funktionsschicht (5) an der Oberseite (2a) der Trägerschicht (2) angeordnet ist und ein Material aufweist, das einen temperaturabhängigen elektrischen Widerstand hat, wobei das Sensorelement (1) dazu ausgebildet ist als diskretes Bauelement direkt in ein elektrisches System integriert zu werden. Ferner wird ein Verfahren zur Herstellung eines Sensorelements beschrieben.

## Beschreibung

Die vorliegende Erfindung betrifft ein Sensorelement, insbesondere einen Temperatursensor. Die vorliegende Erfindung betrifft weiterhin ein Verfahren zur Herstellung eines Sensorelements, vorzugsweise eines Temperatursensors.

Um Temperatursensoren, speziell NTC (NTC = Negative Temperature Coefficient) basierte Thermistoren, in heutige, elektrische Systeme zu integrieren, müssen die Dimensionen der Sensorelemente in modere Packaging-Designs passen, die im mikrometer- und sogar im nanometer-skaligen Bereich liegen. Um diesen Miniaturisierungsgrad zu erreichen, werden Sensoren als dünne Filme auf Trägerstrukturen mit elektrischen Anschlüssen abgeschieden und als diskretes Bauelement beschrieben.

Bislang sind NTC Thermistoren als "bare die" (ungehäuster Halbleiterchip) oder in SMD (Surface Mounted Device) Bauweise auf Leiterplatten verfügbar. Für die Integration von Temperatursensorelementen in beispielsweise MEMS- (Mikro Elektro Mechanisches System) oder SESUB- (Semiconductor Embedded in Substrate) Strukturen sind diese technischen Lösungen jedoch nicht geeignet. Für diese Systeme sind sehr kleine Elemente notwendig, die darüber hinaus noch mit geeigneten Kontaktierungsverfahren integrierbar sein müssen. Klassische Lötverfahren für SMD Bauformen oder Drahtbondtechnologien für "bare dies" können dafür nicht verwendet werden. Daher sind bislang keine Temperatursensoren als diskrete Bauelemente für eine direkte Integrierung für MEMS oder SESUB Strukturen verfügbar.

Diese Aufgabe wird durch ein Sensorelement und ein Verfahren zur Herstellung eines Sensorelements gemäß der unabhängigen Ansprüche gelöst.

Gemäß einem Aspekt wird ein Sensorelement beschrieben. Das Sensorelement ist zur Messung einer Temperatur ausgebildet. Das Sensorelement ist ein Temperatursensor. Das Sensorelement weist wenigstens eine Trägerschicht auf. Die Trägerschicht weist eine Oberseite und eine Unterseite auf. Die Trägerschicht weist ein Trägermaterial auf. Vorzugsweise weist die Trägerschicht Silicium, Siliciumcarbid oder Glas (silicatisches oder borosilicatisches Glas) auf.

Das Sensorelement weist ferner wenigstens eine Funktionsschicht oder Sensorschicht auf. Das Sensorelement kann auch mehr als eine Funktionsschicht aufweisen, beispielsweise zwei oder drei Funktionsschichten. Die Funktionsschicht weist ein Material auf (Sensormaterial), das einen temperaturabhängigen elektrischen Widerstand hat. Vorzugsweise weist die Funktionsschicht eine NTC Charakteristik auf.

Die Funktionsschicht ist bevorzugt an der Oberseite der Trägerschicht angeordnet. Die Funktionsschicht bedeckt die Oberseite der Trägerschicht vorzugsweise vollständig. Die Funktionsschicht ist unmittelbar auf der Oberseite der Trägerschicht ausgebildet. Insbesondere befindet sich das Sensormaterial form- und materialschlüssig auf dem Material der Trägerschicht. Alternativ dazu ist das Sensormaterial direkt in dem Material der Trägerschicht lokal oder als Schicht erzeugt.

Durch die spezielle Zusammensetzung kann das Sensorelement sehr kompakt ausgeführt werden. Beispielsweise weist das Sensorelement eine Breite von vorzugsweise kleiner oder gleich 500 pm auf, zum Beispiel 100 pm oder 250 µm. Das Sensorelement 1 weist ferner eine Länge von vorzugsweise kleiner oder gleich 500 pm auf, zum Beispiel 100 pm oder 250 µm. Das Sensorelement weist vorzugsweise eine Höhe bzw. Dicke von kleiner oder gleich 100 pm, beispielsweise 50 pm auf.

Folglich ist das Sensorelement sehr kompakt ausgeführt, so dass es als komplettes Bauelement in ein elektrisches System, wie eine Leiterplatte oder einen Siliciumchip integriert werden kann. Insbesondere ist das Sensorelement dazu ausgebildet als diskretes Bauelement direkt in ein elektrisches System eingebettet zu werden. Beispielsweise ist das Sensorelement zur direkten Integration in eine MEMS Struktur und/oder in eine SESUB Struktur ausgebildet.

In einer Ausführungsform weist die Funktionsschicht eine Dünnfilm Schicht, insbesondere eine Dünnfilm NTC Schicht, auf. Mit anderen Worten, die Funktionsschicht weist nur eine sehr geringe Dicke auf. Beispielsweise weist die Funktionsschicht eine Dicke d von 10 nm ≤ d ≤ 1 pm auf, zum Beispiel 500 nm. Auf diese Weise wird ein sehr kleines, diskretes Bauelement zur Verfügung gestellt, dass problemlos in bestehende Strukturen eingebettet werden kann.

In einer Ausführungsform weist die Funktionsschicht ein halbleitendes Material basierend auf Siliciumcarbid in der hexagonalen, Wurtzit-ähnlichen Struktur oder der kubischen Phase im Zinkblende Strukturtyp auf. Alternativ dazu kann die Funktionsschicht ein Metallnitrid im Wurtzit Strukturtyp aufweisen. Diese Materialien ermöglichen das Abscheiden der Funktionsschicht auf der Trägerschicht als stabile Dünnfilm Sensorschicht. Damit kann ein zuverlässiges und kompaktes Sensorelement zur Verfügung gestellt werden.

In einer Ausführungsform weist das Sensorelement eine Schutzschicht auf. Die Schutzschicht ist an einer Oberseite des Sensorelements angeordnet. Die Schutzschicht bedeckt die Oberseite des Sensorelements vorzugsweise vollständig.

Beispielsweise ist die Schutzschicht auf einer Oberseite der Funktionsschicht ausgebildet. Die Schutzschicht kann aber auch auf Strukturen ausgebildet sein, die auf der Funktionsschicht angeordnet sind. Die Schutzschicht schützt das Sensorelement vor äußeren Einflüssen. Vorzugsweise weist die Schutzschicht SiO₂ auf.

In einer weiteren Ausführungsform kann auch wenigstens eine Seitenfläche, bevorzugt alle Seitenflächen, des Sensorelements von einer Schutzschicht überzogen sein. Diese Schutzschicht weist ebenfalls vorzugsweise SiO₂ auf. Insbesondere besteht diese Schutzschicht vorzugsweise aus SiO₂.

In einer Ausführungsform weist das Sensorelement wenigstens eine Durchführung auf. Das Sensorelement kann auch mehr als eine Durchführung aufweisen, beispielsweise zwei oder vier Durchführungen. Die Durchführung weist ein metallisches Material auf. Die Durchführung durchdringt die Trägerschicht vollständig. Mit anderen Worten, die Durchführung reicht von der Funktionsschicht an der Oberseite der Trägerschicht bis hin zur Unterseite der Trägerschicht. Die Unterseite der Trägerschicht ist dabei diejenige Seite der Trägerschicht bzw. des Sensorelements, welche auf dem elektronischen System, in welches das Sensorelement integriert wird, bzw. auf einer Komponente des elektronischen Systems, aufliegt.

In einer alternativen Ausführungsform kann die Durchführung zusätzlich auch die Funktionsschicht vollständig durchdringen. In diesem Fall reicht die Durchführung von einer Oberseite der Funktionsschicht durch die Funktionsschicht und die Trägerschicht hindurch bis hin zur Unterseite der Trägerschicht.

An der Unterseite der Trägerschicht ist ferner wenigstens ein Kontaktelement zur elektrischen Kontaktierung des Sensorelements ausgebildet. Das Sensorelement kann aber auch mehr als ein Kontaktelement aufweisen, beispielsweise zwei oder vier Kontaktelemente. Das Kontaktelement ist an der Unterseite der Trägerschicht unmittelbar mit der Durchführung verbunden.

Das Kontaktelement kann beispielsweise einen Bump oder eine dünne Elektrode aufweisen. Durchführung und Kontaktelement stellen die elektrischen Kontakt- und Verbindungsflächen dar, mit Hilfe derer das Sensorelement elektrisch kontaktiert werden kann. Klassische Lötverfahren für SMD Bauformen oder Drahtbonden zur elektrischen Kontaktierung können demnach entfallen. Damit ist das Sensorelement hervorragend dazu geeignet in eine MEMS oder SESUB Struktur integriert zu werden.

In einer Ausführungsform weist das Sensorelement ferner wenigstens eine Deckelektrode auf. Die Deckelektrode weist beispielsweise Au, Ni, Cr, Ag, W, Ti oder Pt auf. Die Deckelektrode ist zur elektrischen Kontaktierung der Funktionsschicht von einer Oberseite der Funktionsschicht her ausgebildet. Damit kann das Sensorelement auf zuverlässige Weise von der Unterseite her über die Durchführung und das Kontaktelement und von der Oberseite her über die Deckelektrode kontaktiert werden.

Vorzugsweise ist die Deckelektrode unmittelbar auf der Funktionsschicht angeordnet. Insbesondere ist die Deckelektrode auf der Oberseite der Funktionsschicht abgeschieden. Die Deckelektrode kann auf die Funktionsschicht aufgesputtert sein. Die Deckelektrode weist einen dünnen Metallfilm auf. Vorzugsweise ist die Deckelektrode eine Dünnschicht-Elektrode. Die Deckelektrode kann einschichtig oder mehrschichtig ausgebildet sein. Beispielsweise weist die Deckelektrode eine Dicke d von 10 nm ≤ d ≤ 1 pm auf, zum Beispiel 500 nm. Auf diese Weise wird ein sehr kompaktes Bauelement zur direkten Integration in ein elektrisches System zur Verfügung gestellt.

In einer Ausführungsform weist das Sensorelement wenigstens zwei Deckelektroden auf. Vorzugsweise sind die Deckelektroden nebeneinander angeordnet. Die jeweilige Deckelektrode bedeckt dabei lediglich einen Teil der Oberseite der Funktionsschicht.

Die Deckelektroden sind durch wenigstens eine Aussparung bzw. wenigstens einen Spalt räumlich und elektrisch voneinander getrennt. Durch die Größe (insbesondere die Breite) der Aussparung und damit die Größe des Abstands zwischen den Deckelektroden kann der Widerstand des Sensorelements variiert bzw. eingestellt werden.

An Stelle einer Aussparung kann auch eine kammartig ineinandergreifende Struktur zwischen den beiden Deckelektroden vorgesehen sein. Auf diese Weise wird die Fläche zwischen den Deckelektroden vergrößert. Ferner wird durch die kammartige Struktur der Widerstand des Sensorelements und auch eine Streuung des Widerstands verringert.

Gemäß einem Aspekt wird ein Verfahren zur Herstellung eines Sensorelements beschrieben. Vorzugsweise wird durch das Verfahren das oben beschriebene Sensorelement hergestellt. Alle Eigenschaften, die in Bezug auf das Sensorelement oder das Verfahren offenbart sind, sind auch entsprechend in Bezug auf den jeweiligen anderen Aspekt offenbart und umgekehrt, auch wenn die jeweilige Eigenschaft nicht explizit im Kontext des jeweiligen Aspekts erwähnt wird. Das Verfahren weist die folgenden Schritte auf:
A) Bereitstellen eines Trägermaterials zur Ausbildung der Trägerschicht (Wafer). Das Trägermaterial weist vorzugsweise Si, SiC oder Glas auf. Die durch das Trägermaterial ausgebildete Trägerschicht dient zur Stabilisierung des Sensorelements.
B) Ausbildung von wenigstens einer Durchführung. Die Durchführung durchdringt in diesem Ausführungsbeispiel das Trägermaterial vollständig. Mit anderen Worten es wird ein Durchbruch durch das Trägermaterial erzeugt, welcher später mit einem metallischen Material aufgefüllt wird.
C) Füllen der wenigstens einen Durchführung mit einem metallischen Material, beispielsweise galvanisch. Das metallische Material kann beispielsweise Kupfer oder Gold aufweisen.
D) Beschichten des Trägermaterials mit einem Sensormaterial zur Ausbildung der Funktionsschicht. Das Sensormaterial kann eine Dünnschicht mit einer NTC Charakteristik aufweisen. Das Beschichten erfolgt vorzugsweise mittels eines PVD ("physical vapour deposition") Prozesses, eines CVD ("chemical vapour deposition") Prozesses oder galvanisch. Die dabei resultierende Funktionsschicht ist vorzugsweise eine Dünnfilm NTC Schicht.

Optional kann anschließend ein Temperschritt erfolgen.
E) Vereinzeln der Sensorelemente. Dies kann beispielsweise durch Aufbringen von Photolack und anschließendem Plasmaätzen oder Sägen und Einkerben von Funktionsschicht und Trägerschicht erfolgen.

Durch das Verfahren wird ein zuverlässiges und kompaktes diskretes Sensorelement erzeugt, welches sich auf einfache Art und Weise in bestehende elektrische Systeme integrieren lässt.

In einer Ausführungsform erfolgt vor Schritt E) ein Abscheiden von wenigstens einer Deckelektrode auf eine Oberseite des Sensormaterials. Dieser Schritt ist optional, das heißt das resultierende Sensorelement kann auch ohne Deckelektrode ausgebildet sein und nur über die Durchführungen und Kontaktelemente von der Unterseite her kontaktiert werden.

Das Abscheiden der Deckelektrode erfolgt vorzugsweise mittels eines PVD Prozesses, eines CVD Prozesses oder galvanisch. Die dabei resultierende Deckelektrode ist vorzugsweise eine Dünnfilm Elektrode.

In einer Ausführungsform wird Schritt D) vor Schritt B) durchgeführt. Mit anderen Worten, die Beschichtung des Trägermaterials mit dem Sensormaterial kann vor der Ausbildung der wenigstens einen Durchführung erfolgen. In diesem Ausführungsbeispiel ragt die Durchführung in die Funktionsschicht hinein und wird von dieser umschlossen. Vorzugsweise durchdringt die Durchführung die Trägerschicht und die Funktionsschicht vollständig.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.

Es zeigen:
- Figur 1: ein Sensorelement in einer ersten Ausführungsform,
- Figur 2: ein Sensorelement in einer zweiten Ausführungsform,
- Figur 3: ein Sensorelement in einer dritten Ausführungsform,
- Figur 4: ein Sensorelement in einer vierten Ausführungsform,
- Figur 5: ein Sensorelement in einer fünften Ausführungsform,
- Figuren 6 bis 10: ein Verfahren zur Herstellung eines Sensorelements.

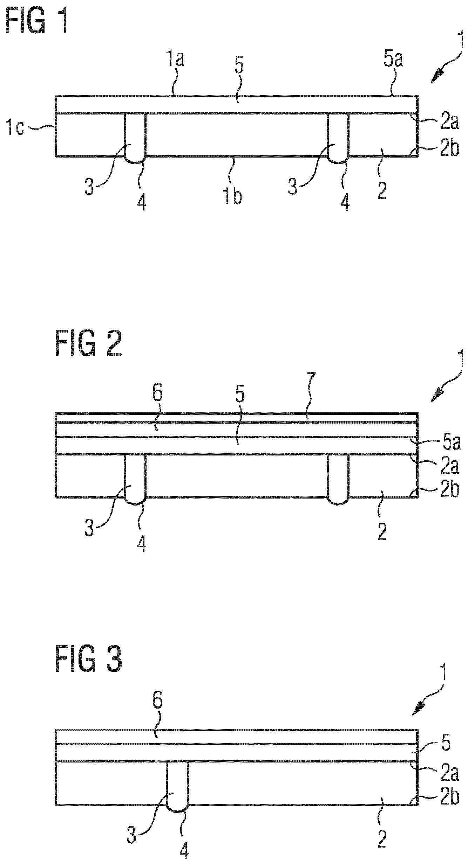

Die Figur 1 zeigt ein Sensorelement 1 gemäß einer ersten Ausführungsform. Das Sensorelement 1 ist vorzugsweise zur Messung einer Temperatur ausgebildet. Das Sensorelement 1 weist wenigstens eine Trägerschicht 2 bzw. einen Wafer 2 auf. Die Trägerschicht 2 weist eine Oberseite 2a und eine Unterseite 2b auf. Die Trägerschicht 2 weist ein Trägermaterial, vorzugsweise Silicium (Si), Siliciumcarbid (SiC) oder Glas auf. Die Trägerschicht 2 dient der mechanischen Stabilisierung des Sensorelements 1.

Das Sensorelement 1 weist ferner wenigstens eine Funktionsschicht 5 oder Sensorschicht 5 auf. In diesem Ausführungsbeispiel weist das Sensorelement 1 genau eine Funktionsschicht 5. Aber es sind auch mehrere Funktionsschichten 5 vorstellbar, beispielsweise zwei, drei oder vier Funktionsschichten 5, die beispielsweise nebeneinander oder übereinander angeordnet sein können.

Die Funktionsschicht 5 ist in diesem Ausführungsbeispiel an der Oberseite 2a der Trägerschicht 2 angeordnet. Die Funktionsschicht 5 bedeckt die Oberseite 2a der Trägerschicht 2 vorzugsweise vollständig. Die Funktionsschicht 5 ist form- und materialschlüssig auf der Trägerschicht 2 angeordnet. Alternativ dazu ist die Funktionsschicht 5 direkt in dem Trägermaterial lokal oder als Schicht erzeugt.

Die Funktionsschicht 5 weist ein Material auf, das einen temperaturabhängigen elektrischen Widerstand aufweist, vorzugsweise ein Material mit NTC R/T Charakteristik. Vorzugsweise ist die Funktionsschicht 5 als Dünnfilm NTC Schicht auf der Trägerschicht 2 ausgebildet. Die Funktionsschicht 5 weist eine sehr geringe Dicke von kleiner oder gleich 1 pm auf.

Beispielsweise weist die Funktionsschicht 5 ein halbleitendes Material basierend auf SiC in der hexagonalen, Wurtzit-ähnlichen Struktur oder der kubischen Phase im Zinkblende Strukturtyp auf. Das Siliciumcarbid kann dabei in reiner Form, dotiert (beispielsweise mit Ti, Cr, N, Be, B, Al, Ga) oder als Mischkristall (beispielsweise (SiC)ₓ(AlN)₁₋ₓ) vorliegen, bzw. intermetallische Phasen wie zum Beispiel Al₄SiC₄, Ti₃SiC₂ oder Y₃Si₂C₂ enthalten.

Alternativ dazu kann die Funktionsschicht 5 auch auf Metallnitriden im Wurtzit Strukturtyp basieren, wie AlN oder GaN. AlN kann in reiner Form, als Mischkristall (beispielsweise (AlₓTi₁₋ₓ)(N_{y}O_{1-y}) oder AlₓGa₁₋ₓN, mit 0 ≤ x, y ≤ 1) oder dotiert (beispielsweise mit Si, Mg, C, Ge, Se oder Zn) vorliegen.

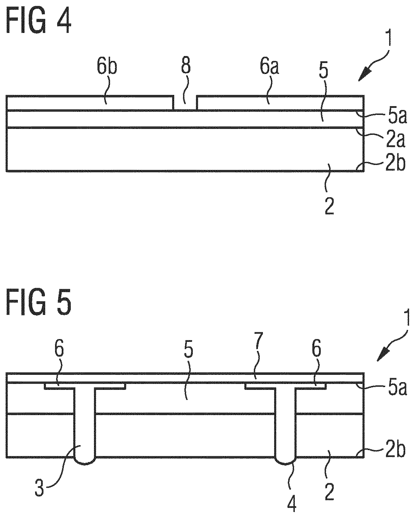

In diesem Ausführungsbeispiel weist die Trägerschicht 2 ferner zwei Durchführungen 3 auf. Alternativ dazu kann das Sensorelement 1 auch nur eine Durchführung 3 (siehe hierzu die Figur 3) oder gar keine Durchführung 3 (siehe hierzu die Figur 4) aufweisen. Ferner sind auch mehr als zwei Durchführungen 3, beispielsweise drei oder vier Durchführungen vorstellbar (nicht explizit dargestellt).

Die jeweilige Durchführung 3 durchdringt die Trägerschicht 2 vollständig. Mit anderen Worten, die Durchführung 3 ragt von der Oberseite 2a bis zur Unterseite 2b der Trägerschicht 2. Die Durchführung 3 weist ein metallisches Material auf, beispielsweise Kupfer oder Gold.

Das in Figur 1 gezeigte Sensorelement 1 weist ferner zwei Kontaktelemente 4 auf. Die Kontaktelemente 4 sind an der Unterseite 2a der Trägerschicht 2 angeordnet. Die Kontaktelemente 4 sind direkt bzw. unmittelbar an den Durchführungen 3 ausgebildet. Die Kontaktelemente 4 stehen in elektrischem und mechanischem Kontakt mit den Durchführungen 3. Die Kontaktelemente 4 dienen zur elektrischen Kontaktierung des Sensorelements 1. Ferner kann das Sensorelement 1 über die Kontaktelemente 4 beispielsweise auf andere Komponenten eines elektrischen Systems gestackt werden.

Die Kontaktelemente 4 können beispielsweise als Bumps oder als dünne Elektrode ausgeführt sein. Die Kontaktelemente 4 weisen ein Metall, beispielsweise Kupfer, Gold oder lötbare Legierungen auf. Die Durchführungen 3 dienen dazu die Funktionsschicht 5 an der Oberseite 2a der Trägerschicht 2 mit den Kontaktelementen 4 an der Unterseite 2a der Trägerschicht 2 zu verbinden und damit die Funktionsschicht 5 elektrisch zu kontaktieren. Damit wird ein robustes und verlässliches Sensorelement 1 bereit gestellt.

In einem weiteren Ausführungsbeispiel (nicht explizit dargestellt) ist an einer Oberseite 1a des Sensorelements 1 ferner eine Schutzschicht 7 angeordnet. Die Schutzschicht 7 ist in diesem Fall unmittelbar auf der Funktionsschicht 5 ausgebildet. Die Schutzschicht 7 bedeckt eine Oberseite 5a der Funktionsschicht 5 vollständig. Die Schutzschicht 7 weist vorzugsweise SiO₂ auf. Die Schutzschicht 7 dient dem Schutz der Funktionsschicht 5 und des Sensorelements 1 vor äußeren Einflüssen (siehe hierzu auch Figur 2).

Das Sensorelement 1 ist durch seine spezielle Kontaktierung (Durchführungen 3, Kontaktelemente 4) und den speziellen Schichtaufbau (Dünnfilm NTC Schicht) so konzipiert, dass es als komplettes Bauelement in einem Si-Chip oder auf eine Leiterplatte integriert werden kann. Insbesondere ist das Sensorelement 1 dazu ausgebildet als diskretes Bauelement in MEMS oder SESUB Strukturen integriert zu werden.

Insgesamt ist das Sensorelement 1 sehr kompakt ausgeführt. Das Sensorelement 1 weist eine sehr geringe Abmessung auf. Das Sensorelement 1 weist eine Breite von vorzugsweise kleiner oder gleich 500 pm auf, beispielsweise 50 pm, 100 pm, 250 pm, 300 pm, 400 µm oder 450 µm. Das Sensorelement 1 weist eine Länge von vorzugsweise kleiner oder gleich 500 pm auf, beispielsweise 50 pm, 100 pm, 250 pm, 300 pm, 400 µm oder 450 pm. Vorzugsweise weist das Sensorelement 1 eine rechteckige Grundform auf. Das Sensorelement 1 weist eine Höhe (Ausdehnung in Stapelrichtung) von vorzugsweise kleiner oder gleich 100 µm, beispielsweise 10 pm, 50 µm oder 80 pm auf.

Durch die kompakte Bauweise und die Kontaktierung mittels den Durchführungen 3 und den Kontaktelementen 4 eignet sich das Sensorelement 1 hervorragend zur Integration in MEMS oder SESUB Strukturen.

Die Figur 2 zeigt ein Sensorelement 1 in einer zweiten Ausführungsform. Im Unterschied zu dem in Zusammenhang mit Figur 1 beschriebenen Sensorelement 1 weist das Sensorelement 1 gemäß Figur 2 zusätzlich eine Deckelektrode 6 auf. Die Deckelektrode 6 ist auf der Oberseite 5a der Funktionsschicht 5 angeordnet. Insbesondere ist die Deckelektrode 6 unmittelbar auf der Funktionsschicht 5 aufgebracht. In diesem Ausführungsbeispiel bedeckt die Deckelektrode 6 die Oberseite 5a der Funktionsschicht 5 vollständig. Die Funktionsschicht 5 kann mittels der Deckelektrode 6 von der Oberseite her kontaktiert werden. Die unterseitige Kontaktierung erfolgt über die Durchführungen 3 und Kontaktelemente 4.

Die Deckelektrode 6 weist ein metallisches Material, bevorzugt Au, Ni, Cr, Ag, W, Ti oder Pt auf. Vorzugsweise ist die Deckelektrode 6 auf der Funktionsschicht 5 abgeschieden, zum Beispiels mittels eines PVD oder CVD Prozesses oder galvanisch. Bevorzugt ist die Deckelektrode 6 auf der Funktionsschicht 5 aufgesputtert. Die Deckelektrode 6 ist eine Dünnschichtelektrode. Mit anderen Worten, die Deckelektrode 6 weist bevorzugt einen dünnen Metallfilm auf. Die Deckelektrode 6 weist eine Dicke d bzw. Höhe von ≥ 100 nm und ≤ 1 µm auf, beispielsweise 500 nm.

In diesem Ausführungsbeispiel weist das Sensorelement 1 ferner die bereits in Zusammenhang mit Figur 1 beschriebene Schutzschicht 7 auf. Die Deckelektrode 6 ist daher im gezeigten Fall zwischen Funktionsschicht 5 und Schutzschicht 7 angeordnet. Anders ausgedrückt, die Schutzschicht 7 ist in diesem Ausführungsbeispiel unmittelbar auf der Deckelektrode 6 ausgebildet.

In einem alternativen Ausführungsbeispiel (nicht explizit dargestellt) kann die Schutzschicht 7 aber auch entfallen. In diesem Fall bildet die Deckelektrode 6 die Oberseite des Sensorelements 1. In diesem Ausführungsbeispiel besteht die Möglichkeit eine zusätzliche Kontaktierung, beispielsweise durch Drahtbonden auf der Deckelektrode 6 zu realisieren (nicht explizit dargestellt).

In Bezug auf alle weiteren Merkmale des Sensorelements 1 gemäß Figur 2 wird auf die Beschreibung zu Figur 1 verwiesen.

Die Figur 3 zeigt ein Sensorelement 1 in einer dritten Ausführungsform. In diesem Ausführungsbeispiel weist das Sensorelement 1 lediglich eine Durchführung 3 und ein Kontaktelement 4 auf, wodurch die Funktionsschicht 5 von der Unterseite her kontaktiert wird. Das Kontaktelement 4 kann wie bereits beschrieben als Bump oder als dünne Elektrode ausgeführt sein.

Das Sensorelement 1 weist in diesem Ausführungsbeispiel ferner die bereits in Zusammenhang mit Figur 2 beschriebene Deckelektrode 6 auf. Anders als bei Figur 2 ist die Deckelektrode 6 in diesem Ausführungsbeispiel zur (oberseitigen) Kontaktierung der Funktionsschicht 5 zwingend erforderlich. In Bezug auf alle weiteren Merkmale des Sensorelements 1 gemäß Figur 3 wird auf die Beschreibung zu Figur 1 und zu Figur 2 verwiesen.

Die Figur 4 zeigt ein Sensorelement 1 in einer vierten Ausführungsform. In diesem Ausführungsbeispiel weist das Sensorelement 1 keine Durchführungen 3 und auch keine Kontaktelemente 4 an der Unterseite 2a der Trägerschicht 2 auf. Vielmehr wird die Funktionsschicht 5 hier ausschließlich von der Oberseite her kontaktiert. Insbesondere weist das Sensorelement 1 zwei Deckelektroden 6a, 6b zum elektrischen Anschluss des Sensorelements 1 auf. Die Deckelektroden 6a, 6b sind unmittelbar auf der Funktionsschicht 5 ausgebildet, vorzugsweise abgeschieden, wie bereits in Zusammenhang mit Figur 2 erläutert wurde. Die Deckelektroden 6a, 6b sind nebeneinander auf der Funktionsschicht 5 angeordnet.

Die jeweilige Deckelektrode 6a, 6b kann einschichtig oder mehrschichtig ausgebildet sein. Die jeweilige Deckelektrode 6a, 6b ist vorzugsweise eine Dünnschichtelektrode. Die jeweilige Deckelektrode 6a, 6b weist vorzugsweise wenigstens eine gesputterte Metallschicht auf. Beispielsweise weist die jeweilige Deckelektrode 6a, 6b Au, Ni, Cr, Ag, W, Ti oder Pt auf. Vorzugsweise weist die jeweilige Deckelektrode 6a, 6b eine Dicke bzw. Höhe zwischen 100 nm und 1 pm auf.

Die Deckelektroden 6a, 6b bilden in diesem Ausführungsbeispiel die Oberseite des Sensorelements 1. Alternativ dazu (nicht explizit dargestellt) kann aber auch eine Schutzschicht 7 vorgesehen sein, die auf den Deckelektrode 6a, 6b angeordnet ist.

Die Deckelektroden 6a, 6b sind elektrisch voneinander getrennt. Zu diesem Zweck ist wenigstens eine Aussparung bzw. einen Spalt 8 zwischen den Deckelektroden 6a, 6b ausgebildet, wie in Figur 4 dargestellt ist. Diese Aussparung 8 trennt die Deckelektroden 6a, 6b räumlich und elektrisch. Mit der Größe (horizontale Ausdehnung, also Ausdehnung senkrecht zur Stapelrichtung) der Aussparung 8 kann der Widerstand des Sensorelements 1 eingestellt werden. Wird die Aussparung 8 verkleinert, so sinkt der Widerstand. Dadurch wird aber auch eine Streuung des Widerstands vergrößert. Um dies zu vermeiden bzw. um die Fläche zwischen den Deckelektroden 6a, 6b zu vergrößern und damit den Widerstand zu verringern, kann auch eine Kammstruktur zwischen den Deckelektroden 6 vorgesehen sein (nicht explizit dargestellt). Die Deckelektroden 6 sind in diesem Fall ineinandergreifend nebeneinander angeordnet.

Die Figur 5 zeigt ein Sensorelement 1 in einer fünften Ausführungsform. In diesem Ausführungsbeispiel weist das Sensorelement 1 zwei Durchführungen 3, zwei Kontaktelemente 4, sowie zwei Deckelektroden 6 auf.

Im Vergleich zu dem in Figur 1 gezeigten Ausführungsbeispiel durchdringen in diesem Ausführungsbeispiel die Durchführungen 3 nicht nur die Trägerschicht 2 sondern auch die Funktionsschicht 5 vollständig. Insbesondere ragt die jeweilige metallische Durchführung 3 in die Funktionsschicht 5 und wird von dieser umschlossen. Die jeweilige Durchführung erstreckt sich damit von der Unterseite 2b der Trägerschicht 2 durch die Trägerschicht 2 und die Funktionsschicht 5 hindurch bis hin zur Oberseite 5a der Funktionsschicht 5.

An der Oberseite der jeweiligen Durchführung 3 ist jeweils eine Deckelektrode 6 ausgebildet. Auch die jeweilige Deckelektrode 6 ist in diesem Ausführungsbeispiel zumindest teilweise in die Funktionsschicht 5 eingebettet. Die Deckelektroden 6 bilden damit zumindest teilweise die Oberseite 5a der Funktionsschicht 5.

Unmittelbar auf der Funktionsschicht 5 ist die Schutzschicht 7 ausgebildet. Die Schutzschicht 7 bedeckt in diesem Fall die Oberseite 5a der Funktionsschicht 5, welche zumindest teilweise durch die Deckelektroden 6 gebildet wird.

Die unterseitige Kontaktierung erfolgt über Durchführungen 3 und Kontaktelemente 4, beispielsweise Bumps. Es können dabei auch mehr als die in Figur 5 dargestellten Durchführungen vorgesehen sein, beispielsweise vier Durchführungen. Ferner befindet sich in diesem Ausführungsbeispiel eine Schutzschicht 7 an der Oberseite 1a des Sensorelements 1.

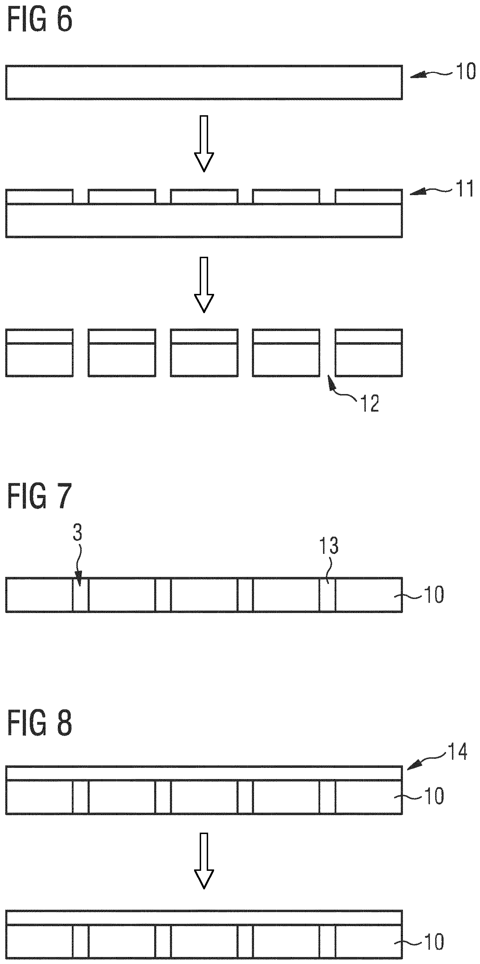

Die Figuren 6 bis 10 zeigen ein Verfahren zur Herstellung eines Sensorelements 1. Vorzugsweise wird durch das Verfahren das Sensorelement 1 gemäß einem der oben beschriebenen Ausführungsbeispiele hergestellt. Alle Merkmale die in Zusammenhang mit dem Sensorelement 1 beschrieben wurden, finden daher auch für das Verfahren Anwendung und umgekehrt.

In einem ersten Schritt A) wird ein Trägermaterial 10 zur Ausbildung der oben beschriebenen Trägerschicht 2 bereitgestellt (siehe Figur 6 oben). Vorzugsweise weist das Trägermaterial 10 Si, SiC oder Glas auf.

In einem nächsten Schritt B) werden die oben beschriebenen Durchführungen 3 hergestellt. Dazu werden Vias / Durchbrüche 12 beispielsweise durch Photolithographie und anschließendem Plasmaätzen ("dry etching") in dem Trägermaterial 10 erzeugt (siehe Figur 6 Mitte und unten). Alternativ lassen sich die Vias 12 auch mit einem Laser erzeugen (Laserdrilling).

Die Vias / Durchbrüche 12 werden in einem Schritt C) mit einem metallischen Material 13 (beispielsweise Kupfer) gefüllt, beispielsweise galvanisch (siehe hierzu Figur 7). Der bei der Photolithographie verwendete Photolack 11 (siehe Figur 6) wird anschließend abgewaschen.

In einem weiteren Schritt D) erfolgt das Beschichten des Trägermaterials 10 mit einem Sensormaterial 14 zur Ausbildung der Funktionsschicht 5 (siehe hierzu Figur 8). Das Sensormaterial 14 weist beispielsweise eine NTC Keramik auf. Die Beschichtung erfolgt bevorzugt durch einen PVD oder CVD Prozess. Dabei wird ein dünner Sensorfilm auf dem Trägermaterial 10 erzeugt (Dünnfilm NTC). Optional kann nach Schritt D) ein Temperschritt erfolgen.

Der Verfahrensschritt D) kann in einem alternativen Ausführungsbeispiel auch vor dem Erzeugen der Vias / Durchbrüche 12 (Schritt B)) erfolgen. In diesem Fall ragt das metallische Material 13 in die Funktionsschicht 5 hinein und wird von dieser umschlossen (siehe hierzu auch das in Zusammenhang mit Figur 5 beschriebene Ausführungsbeispiel).

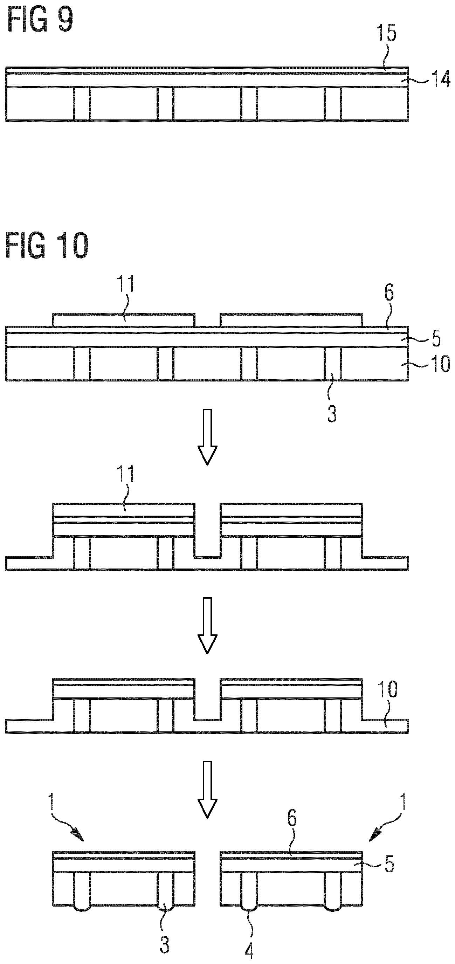

In einem weiteren Schritt erfolgt das Abscheiden von Elektrodenmaterial 15 zur Ausbildung der wenigstens einen Deckelektrode 6 (siehe hierzu Figur 9 in Zusammenhang mit den Figuren 2 bis 5). Das Elektrodenmaterial 15 weist vorzugsweise Au, Ni, Cr, Ag, W, Ti oder Pt auf. Das Abscheiden erfolgt durch einen PVD oder CVD Prozess oder galvanisch. Es wird dabei eine einschichtige oder mehrschichtige dünne Deckelektrode 6 (Dünnschichtelektrode) erzeugt. Insbesondere wird die Deckelektrode 6 bei diesem Verfahrensschritt als dünner Elektrodenfilm auf dem Sensormaterial 14 abgeschieden. Werden zwei Deckelektroden 6 abgeschieden, so wird eine Aussparung (siehe Figur 4) oder eine kammartige Struktur zur elektrischen Trennung der Deckelektroden 6a, 6b vorgesehen.

In einem optionalen Schritt kann weiterhin das Ausbilden der Schutzschicht 7 durch Aufbringen des entsprechenden Materials (vorzugsweise SiO₂) entweder auf das Sensormaterial 14 (Ausführungsbeispiel gemäß Figur 1) oder auf das Elektrodenmaterial 15 (Ausführungsbeispiele gemäß Figuren 2 bis 5) erfolgen.

In einem letzten Schritt E) werden die Sensorelemente 1 vereinzelt (siehe hierzu Figur 10). Dies erfolgt durch Aufbringen von Photolack 11 und anschließendem Plasmaätzen oder Sägen der Funktionsschicht 5 und dem Teil des Trägermaterials 10 welcher die Höhe bzw. Dicke der späteren Trägerschicht 2 bestimmt (Einkerben).

Alternativ dazu kann das Abdünnen des Trägermaterials 10 auf der Unterseite in zwei Schritten erfolgen, wobei in einem ersten Schritt das Trägermaterial 10 flächig weggeätzt oder abgeschliffen wird, und in einem zweiten Schritt die Vereinzelung durch ein flächiges Ätzen erfolgt und die Kontaktelemente 4 freigelegt werden, ohne das Metall dabei zu oxidieren.

Die Beschreibung der hier angegebenen Gegenstände ist nicht auf die einzelnen speziellen Ausführungsformen beschränkt. Vielmehr können die Merkmale der einzelnen Ausführungsformen - soweit technisch sinnvoll - beliebig miteinander kombiniert werden.

### Bezugszeichenliste

- 1: Sensorelement
- 1a: Oberseite des Sensorelements
- 1b: Unterseite des Sensorelements
- 1c: Seitenfläche des Sensorelements
- 2: Trägerschicht / Wafer
- 2a: Oberseite der Trägerschicht
- 2b: Unterseite der Trägerschicht
- 3: Durchführung
- 4: Kontaktelement
- 5: Funktionsschicht / Sensorschicht
- 5a: Oberseite der Funktionsschicht
- 6, 6a, 6b: Deckelektrode
- 7: Schutzschicht
- 8: Aussparung
- 10: Trägermaterial
- 11: Photolack
- 12: Via
- 13: Metallisches Material
- 14: Sensormaterial
- 15: Elektrodenmaterial

## Patentansprüche

1. Sensorelement (1) zur Messung einer Temperatur aufweisend
- wenigstens eine Trägerschicht (2), wobei die Trägerschicht (2) eine Oberseite (2a) und eine Unterseite (2b) aufweist,
- wenigstens eine Funktionsschicht (5), wobei die Funktionsschicht (5) an der Oberseite (2a) der Trägerschicht (2) angeordnet ist und ein Material aufweist, das einen temperaturabhängigen elektrischen Widerstand hat,
- wenigstens eine Deckelektrode (6, 6a, 6b), wobei die Deckelektrode (6, 6a, 6b) zur elektrischen Kontaktierung der Funktionsschicht (5) von einer Oberseite (5a) der Funktionsschicht (5) her ausgebildet ist,
wobei das Sensorelement (1) dazu ausgebildet ist als diskretes Bauelement direkt in ein elektrisches System integriert zu werden.

2. Sensorelement (1) nach Anspruch 1,
wobei die Deckelektrode (6, 6a, 6b) unmittelbar auf der Funktionsschicht (5) angeordnet ist.

3. Sensorelement (1) nach Anspruch 1 oder 2,
wobei die Deckelektrode (6, 6a, 6b) wenigstens eine gesputterte Schicht aufweist.

4. Sensorelement (1) nach einem der vorangehenden Ansprüche, aufweisend wenigstens zwei Deckelektroden (6a, 6b), wobei die Deckelektroden (6a, 6b) nebeneinander angeordnet sind.

5. Sensorelement (1) nach Anspruch 4,
wobei die Deckelektroden (6a, 6b) durch wenigstens eine Aussparung (8) räumlich und elektrisch voneinander getrennt sind.

6. Sensorelement (1) nach Anspruch 5,
wobei mit einer Größe der Aussparung (8) ein Widerstand des Sensorelements (1) eingestellt werden kann.

7. Sensorelement (1) nach Anspruch 4,
wobei eine kammartig ineinandergreifende Struktur zwischen den beiden Deckelektroden (6a, 6b) vorgesehen ist.

8. Sensorelement (1) nach Anspruch 7,
wobei durch die kammartige Struktur ein Widerstand des Sensorelements (1) und eine Streuung des Widerstands verringert wird.

9. Sensorelement (1) nach einem der vorangehenden Ansprüche, wobei die Deckelektrode (6, 6a, 6b) die Oberseite (1a) des Sensorelements (1) bildet.

10. Sensorelement (1) nach einem der vorangehenden Ansprüche, wobei die Deckelektrode (6, 6a, 6b) eine Dicke zwischen 100 nm und 1 pm aufweist.

11. Sensorelement (1) nach einem der vorangehenden Ansprüche, wobei die Trägerschicht (2) Silicium, Siliciumcarbid oder Glas aufweist.

12. Sensorelement (1) nach einem der vorangehenden Ansprüche, wobei die Funktionsschicht (5) eine Dünnfilm NTC Schicht aufweist.

13. Sensorelement (1) nach einem der vorangehenden Ansprüche, wobei die Funktionsschicht (5) ein halbleitendes Material basierend auf Siliciumcarbid in der hexagonalen, Wurtzit-ähnlichen Struktur oder der kubischen Phase im Zinkblende Strukturtyp aufweist oder wobei die Funktionsschicht (5) ein Metallnitrid im Wurtzit Strukturtyp aufweist.

14. Sensorelement (1) nach einem der vorangehenden Ansprüche, ferner aufweisend wenigstens eine Schutzschicht (7), wobei die Schutzschicht (7) an einer Oberseite (1a) des Sensorelements (1) und/oder an wenigstens einer Seitenfläche (1c) des Sensorelements (1) angeordnet ist.

15. Sensorelement (1) nach Anspruch 14, wobei die Schutzschicht (7) SiO₂ aufweist.

16. Sensorelement (1) nach einem der vorangehenden Ansprüche, ferner aufweisend wenigstens eine Durchführung (3), wobei die Durchführung(3) die Trägerschicht (2) vollständig durchdringt, und wobei an der Unterseite (2b) der Trägerschicht (2) wenigstens ein Kontaktelement (4) zur elektrischen Kontaktierung des Sensorelements (1) ausgebildet ist.

17. Sensorelement (1) nach Anspruch 16,
aufweisend wenigstens zwei Durchführungen (3), wobei an der Unterseite (2b) der Trägerschicht (2) zwei Kontaktelemente (4) ausgebildet sind.

18. Sensorelement (1) nach einem der vorangehenden Ansprüche, wobei das Sensorelement (1) zur direkten Integration in eine MEMS Struktur und/oder in eine SESUB Struktur ausgebildet ist.

19. Verfahren zur Herstellung eines Sensorelements (1) aufweisend die folgenden Schritte:
A) Bereitstellen eines Trägermaterials (10) zur Ausbildung der Trägerschicht (2);
B) Ausbildung von wenigstens einer Durchführung (3), wobei die Durchführung (3) das Trägermaterial (10) vollständig durchdringt;
C) Füllen der wenigstens einen Durchführung (3) mit einem metallischen Material (13);
D) Beschichten des Trägermaterials (10) mit einem Sensormaterial (14) zur Ausbildung der Funktionsschicht (5) sowie Abscheiden wenigstens einer Deckelektrode (6, 6a, 6b) auf eine Oberseite des Sensormaterials (14);
E) Vereinzeln der Sensorelemente (1).

20. Verfahren nach Anspruch 19,
wobei das Sensormaterial (14) eine NTC Schicht aufweist.

21. Verfahren nach einem der Ansprüche 19 oder 20,
wobei nach Schritt D) ein Temperschritt erfolgt.

22. Verfahren nach einem der Ansprüche 19 bis 21,
wobei Schritt D) vor Schritt B) durchgeführt wird.
